# FASCICULE DE BREVET EUROPEEN

(11) **EP 3 933 798 B1**
(45) Date de publication et mention de la délivrance du brevet: **10.05.2023**
(21) Numéro de dépôt: 21176266.1
(22) Date de dépôt: 27.05.2021
(51) Int. Cl.: G08C 15/06, H04Q 9/00, B60L 1/00, G01R 31/36, B60L 3/00, B60L 3/12, B60L 58/21, H02J 7/00, H02J 13/00

(54) **PROCÉDÉ DE GESTION D'UNE BATTERIE D'ACCUMULATEURS**
VERFAHREN ZUR STEUERUNGS EINES AKKUPACKS
METHOD FOR MANAGING A BATTERY PACK

(30) Priorité: 30.06.2020 FR 2006846
(43) Date de publication de la demande: 05.01.2022
(73) Titulaire: Renault s.a.s, 92100 Boulogne Billancourt (FR)
(72) Inventeur: CREGUT, Samuel, 78470 Saint Rémy Les Chevreuse (FR)
(74) Mandataire: Renault Group

(56) Documents cités:
- EP-A1- 3 217 464
- US-A1- 2016 325 626

## Description

### DOMAINE TECHNIQUE DE L'INVENTION

La présente invention concerne de manière générale les batteries d'accumulateurs.

Elle s'applique à une batterie d'accumulateurs comprenant un calculateur qui comporte une unité principale et des unités secondaires connectées ensemble par des moyens de communication sans fil.

Elle concerne plus particulièrement un procédé de gestion d'une telle batterie d'accumulateurs, qui comprend une opération récurrente d'échange de données entre l'unité principale et chaque unité secondaire selon un ordre d'échange prédéterminé, à des intervalles de temps successifs compris dans une période de travail déterminée, et en utilisant des canaux de communication différents.

L'invention trouve une application particulièrement avantageuse dans les batteries d'accumulateurs utilisées pour propulser des véhicules automobiles.

### ETAT DE LA TECHNIQUE

Les véhicules automobiles à propulsion électrique ou hybride sont équipés de batteries d'accumulateurs.

Pour que ces batteries puissent propulser les véhicules à des vitesses élevées pendant des durées importantes, elles présentent des capacités et des tensions nominales considérables.

Une telle batterie comporte alors un très grand nombre de cellules électrochimiques de base ayant chacune une tension à ses bornes réduite. Le branchement de ces cellules de base en série permet d'obtenir une batterie d'accumulateurs ayant les propriétés requises.

Pour éviter toute surchauffe ou toute dégradation de ces cellules de base, il s'avère nécessaire de surveiller en continu leur bon état de fonctionnement.

Pour cela, il est connu d'équiper chaque batterie de véhicule automobile d'un calculateur de gestion. Un tel calculateur permet de surveiller, voire aussi de corriger, les éventuels défauts apparaissant dans les cellules de base.

Ces calculateurs se présentent actuellement sous une forme modulaire. Ils comportent ainsi une unité principale (ou « master » en anglais) et des unités secondaires (ou « slave » en anglais) connectées ensemble par des câbles électriques.

Chaque unité secondaire a la charge de la surveillance d'un nombre restreint de cellules de base, et l'unité principale est prévue pour coordonner ces unités secondaires de façon à assurer une gestion efficace de l'ensemble de la batterie d'accumulateurs.

Cette solution s'avère en pratique contraignante à utiliser dans la mesure où elle nécessite un grand nombre de câblages qui sont onéreux, qui sont couteux à installer, et pour lesquels il faut prévoir de la place dans le véhicule. Cette solution présente un autre défaut, qui est qu'elle ne permet pas de réutiliser facilement la batterie en fin de vie dans un parc statique de batteries (sa réutilisation nécessiterait en effet de reprogrammer toutes les unités du calculateur et/ou de reconnecter tous les câbles).

On connaît alors du document US20160056510 un calculateur de gestion de batterie dans lequel les unités principale et secondaires sont connectées ensemble par des moyens de communication sans fil.

Il est ainsi possible d'utiliser des moyens de communication radio dans une bande de fréquence déterminée, par exemple celle des 2,4GHz.

Un tel calculateur permet de remédier aux inconvénients précités, mais souffre d'un problème majeur. Ce problème est celui du risque de perte d'informations lorsque des données sont échangées entre les unités principale et secondaires du calculateur. Il arrive en effet que la liaison radio utilisée se trouve brouillée dans certaines fréquences (appelés « canaux ») de la bande de fréquences.

Une solution connue pour résoudre ce problème consiste alors à utiliser des canaux différents pour transmettre une même donnée (on parle de « channel hopping » en anglais). Ainsi par exemple, la première unité secondaire communiquera des données avec l'unité principale en utilisant tout d'abord un premier des canaux puis, une fois que toutes les unités auront échangé des données avec l'unité principale, elle pourra recommuniquer les mêmes données en utilisant un autre canal.

En pratique, cette solution ne s'avère malheureusement pas assez performante en ce sens qu'elle ne permet pas un échange d'informations aussi rapide que souhaité, notamment lorsque plusieurs unités secondaires souffrent de problèmes de connexion avec l'unité principale,

Le document EP 3 217 464 A1 décrit la correction d'erreurs dans un système de gestion d'une batterie d'accumulateurs en changeant de fréquence de communication.

### PRESENTATION DE L'INVENTION

Afin de remédier à l'inconvénient précité de l'état de la technique, la présente invention propose un procédé qui assure une communication robuste (qui n'est pas altérée lorsque d'autres appareils situés à proximité brouillent les signaux) et déterministe (qui assure une communication de toutes les données émises dans un délai déterminé).

Plus particulièrement, on propose selon l'invention un procédé de gestion d'une batterie d'accumulateurs tel que défini en introduction, qui comprend, au cours de chaque opération récurrente d'échange de données, des étapes de :
- détection d'un ou plusieurs éventuel(s) problème(s) de transmission de données entre l'unité principale et un ensemble d'une ou plusieurs unité(s) secondaire(s), puis, en cas de détection d'au moins un problème (c'est-à-dire si ledit ensemble n'est pas vide),
- sélection d'une unique unité secondaire dans ledit ensemble, compte tenu d'un ordre de priorité prédéterminé, et
- retransmission de données entre ladite unique unité secondaire et l'unité principale pendant un intervalle de temps compris dans ladite période de travail.

Ainsi, le procédé proposé prévoit nativement qu'un problème de communication puisse affecter la liaison entre l'unité principale et un nombre quelconque d'unités secondaires. Il propose dans un tel cas de retransmettre les données qui n'auraient pas été transmises en utilisant un ordre de priorité déterminé de façon à assurer une retransmission de l'ensemble de ces données dans le délai requis.

Ainsi, par exemple, si un nombre n d'unités secondaires ne parviennent pas à transmettre leurs données à l'unité principale pendant plusieurs périodes de travail successives, ces n unités secondaires seront sélectionnées une à une et à tour de rôle pour retransmettre leurs données à la fin de chaque période de travail.

L'avantage majeur de l'invention est alors d'assurer les mêmes chances de réémission des données pour toutes les unités secondaires à chaque période de travail.

D'autres caractéristiques avantageuses et non limitatives du procédé de gestion conforme à l'invention, prises individuellement ou selon toutes les combinaisons techniquement possibles, sont les suivantes :
- en cas de détection d'au moins un problème de transmission (c'est-à-dire si ledit ensemble n'est pas vide), il est prévu une étape de modification de l'ordre de priorité à utiliser pour la période de travail suivante ;
- lors de l'étape de modification, l'ordre de priorité est modifié compte tenu de ladite unique unité secondaire sélectionnée ;
- les unités secondaires étant ordonnées selon une boucle présentant un sens prédéterminé, lors de l'étape de modification, l'ordre de priorité est défini comme suivant le sens prédéterminé et comme partant de l'unité secondaire qui suit ladite unique unité secondaire ;
- ladite étape de sélection est mise en oeuvre par l'unité principale ;
- avant l'étape de retransmission, il est prévu une étape d'émission par l'unité principale vers au moins ladite unique unité secondaire d'une information indiquant qu'elle a été sélectionnée ;
- durant l'opération récurrente d'échange de données, les données sont transmises depuis chaque unité secondaire vers l'unité principale en utilisant un canal à chaque fois différent ;
- durant l'opération récurrente d'échange de données, chaque unité secondaire transmet à l'unité principale des données d'entrée caractérisant l'état de fonctionnement de cellules électrochimiques de ladite batterie d'accumulateurs ;
- durant l'opération récurrente d'échange de données, l'unité principale transmet à chaque unité secondaire des consignes d'équilibrage de cellules électrochimiques de ladite batterie d'accumulateurs.

L'invention concerne aussi une batterie d'accumulateurs comprenant :
- plusieurs ensembles de cellules électrochimiques, et
- un calculateur comportant une unité principale et des unités secondaires qui sont chacune associées à un ensemble respectif de cellules électrochimiques et qui sont connectées à l'unité principale par des moyens de communication sans fil, ce calculateur étant programmé pour mettre en oeuvre un procédé de gestion tel que précité.

L'invention concerne également un véhicule automobile comportant un moteur électrique et une batterie d'accumulateurs telle que précitée.

Bien entendu, les différentes caractéristiques, variantes et formes de réalisation de l'invention peuvent être associées les unes avec les autres selon diverses combinaisons dans la mesure où elles ne sont pas incompatibles ou exclusives les unes des autres.

### DESCRIPTION DETAILLEE DE L'INVENTION

La description qui va suivre en regard des dessins annexés, donnés à titre d'exemples non limitatifs, fera bien comprendre en quoi consiste l'invention et comment elle peut être réalisée.

Sur les dessins annexés :
[Fig. 1] est une vue schématique d'une batterie d'accumulateurs conforme à l'invention ;
[Fig. 2] est un tableau illustrant l'utilisation de différents canaux radio dans le temps, selon un procédé de gestion conforme à l'invention ;
[Fig. 3] est un tableau illustrant un ordre de priorité pour la retransmission de données dans le cadre du procédé de gestion conforme à la présente invention.

L'invention s'applique à tout type de batterie d'accumulateurs.

Elle s'applique plus particulièrement à tout type de véhicule électrique à propulsion électrique ou hybride.

Un tel véhicule automobile comporte au moins un moteur électrique pour propulser le véhicule, et au moins une batterie d'accumulateurs pour alimenter en courant le ou les moteurs électriques.

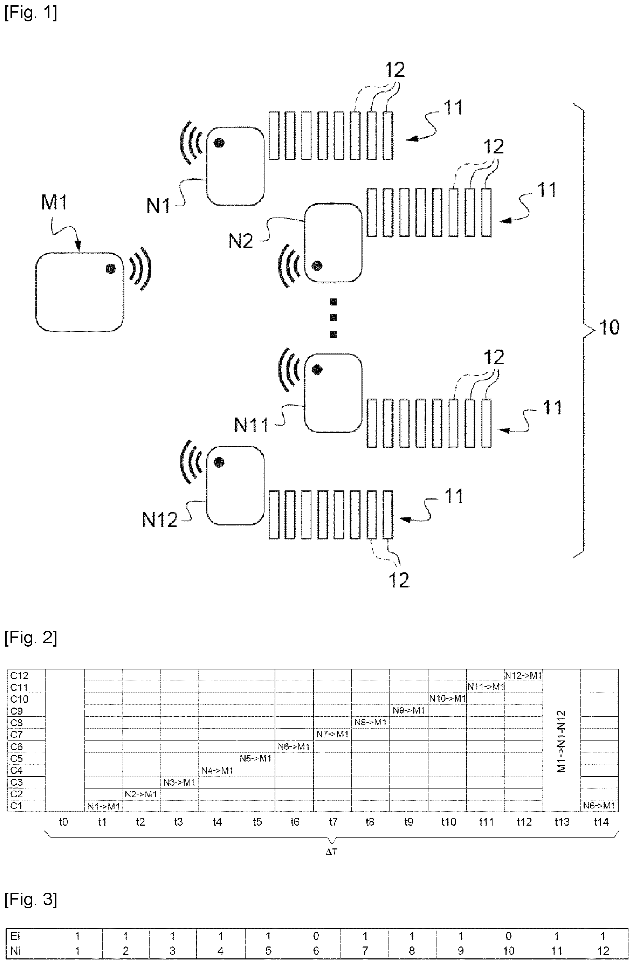

Sur la figure 1, on a représenté la batterie d'accumulateurs 10 d'un tel véhicule.

Elle comporte un grand nombre de cellules électrochimiques 12 branchées en série les unes avec les autres.

Ces cellules électrochimiques 12 sont ici réparties en douze groupes de huit cellules appelés « modules 11 ». Bien entendu, toute autre répartition pourrait être utilisée. On préférera toutefois ici limiter le nombre de modules à seize maximum, pour les raisons qui apparaîtront ci-après.

Chaque module 11 comporte un boîtier de protection qui loge ses huit cellules électrochimiques 12 et qui présente deux bornes (positive et négative) pour son branchement aux autre modules 11.

La batterie d'accumulateurs 10 comprend par ailleurs un calculateur qui permet de surveiller et gérer les cellules électrochimiques 12.

Ce calculateur de gestion comporte une unité principale M1 et des unités secondaires N1-N12. Il est prévu une unité secondaire par module 11. L'unité principale M1 a alors une fonction de coordination des unités secondaires N1-N12.

Chacune de ces unités principale M1 et secondaire N1-N12 comporte une carte électronique.

Les cartes électroniques des douze unités secondaires N1-N12 sont respectivement logées dans les boîtiers de protection des douze modules 11. La carte électronique de l'unité principale M1 est quant à celle située dans un autre boîtier de protection.

L'unité principale M1 et les unités secondaires N1-N12 comportent en pratique chacune un processeur, une mémoire, différentes interfaces d'entrée et des moyens de communication sans fil.

Les interfaces d'entrée de chaque unité secondaire N1-N12 sont connectées aux huit cellules électrochimiques 12 du module 11 correspondant de façon à mesurer les tensions électriques aux bornes de ces cellules. Ici, elles sont également connectées à deux capteurs de température, ce qui permet de mesurer la température dans deux zones distinctes du boîtier de protection du module 11.

Les moyens de communication sans fil comportent pour leur part une antenne radio et une puce de communication adaptée à émettre sur plusieurs canaux radio. Avant chaque émission ou réception de données, cet élément d'émission peut sélectionner un nouveau canal pour échanger des données. Grâce à ces moyens de communication sans fil, chaque unité secondaire N1-N12 est adaptée à communiquer directement avec l'unité principale M1, et vice versa.

Chaque unité secondaire N1-N12 comporte ici des moyens d'équilibrage de ses huit cellules électrochimiques 12. Ces moyens d'équilibrage comportent par exemple des transistors et des résistances, et sont conçues pour équilibrer les différentes cellules de manières qu'elles présentent toute une même tension électrique à leurs bornes.

Grâce aux mémoires des différentes unités principale M1 et secondaires N1-N12, le calculateur de gestion mémorise une application informatique, constituée de programmes d'ordinateur comprenant des instructions dont l'exécution par les différents processeurs permet la mise en oeuvre par le calculateur du procédé décrit ci-après.

Ici, ce procédé utilise le protocole de communication défini par la norme IEEE15.4, lequel fixe 16 canaux (c'est-à-dire 16 bandes de fréquences de largeurs réduites) dans la large bande de fréquence des 2,4 GHz.

Les seize canaux sont indépendants.

Le protocole définissant seize canaux, on comprend la raison pour laquelle on préférera dans notre exemple limiter le nombre de modules 11 à seize, pour qu'à chaque pas de temps, un canal distinct soit affecté à chaque module 11.

Le procédé est alors mis en oeuvre de façon récursive, c'est-à-dire en boucles, à pas de temps réguliers.

La durée de chaque boucle sera appelée ci-après « période de travail ΔT ». Cette période de travail présente une durée prédéfinie et immuable. Elle est généralement de l'ordre de quelques centièmes de secondes, et est par exemple égale à 100ms.

Elle est découpée en intervalles de temps t0-t14 successifs, ici de durées identiques et prédéfinies. Compte tenu du nombre N de modules 11 dans la batterie d'accumulateurs 10, elle est ici découpée en N+3 intervalles de temps, c'est-à-dire ici en quinze intervalles de temps successifs respectivement référencés t0 à t14.

Au cours de chaque période de travail ΔT, chaque module secondaire N1-N12 communiquera des données à l'unité principale M1, et vice versa, à des intervalles de temps t0-t14 distincts.

On peut maintenant décrire en détail comment le procédé est mis en oeuvre.

Au cours du premier intervalle de temps t0, l'unité principale M1 transmet à toutes les unités secondaires N1-N12 des informations requises par la norme IEEE15.4 (clefs de sécurité...). Cette transmission d'information permet notamment de synchroniser les horloges de ces différentes unités principale et secondaires.

Le mode de transmission de données au cours de cet intervalle de temps t0 est donc un mode de diffusion (ou « broadcast » en anglais).

Au cours de l'intervalle de temps t1 qui suit, une première des douze unités secondaires N1-N12 communique des données d'entrée à l'unité principale M1 en utilisant un premier canal C1.

Le mode de transmission de données au cours de cet intervalle de temps t1 est donc un mode direct (ou « one-to-one » en anglais).

La première des douze unités secondaires N1-N12 qui communique ses données d'entrée à l'unité principale M1 est choisie selon un ordre prédéterminé, qui est en pratique immuable d'une période de travail ΔT à l'autre. Ici, les unités secondaires sont référencées de 1 à 12, et émettent donc successivement leurs données d'entrée en fonction de leur numéro de référence.

Au cours de ce premier intervalle de temps t1, la première unité secondaire N1 opère un diagnostic de son électronique, afin de contrôler que son état de fonctionnement est normal ou anormal. Ce diagnostic peut par exemple consister à vérifier que l'unité secondaire N1 reçoit bien des données de tension et de température.

Puis, la première unité secondaire N1 génère une donnée d'entrée relative au fonctionnement du premier module 11.

Ici, cette donnée d'entrée forme une trame de 22 octets, qui contient huit mesures de tensions (codées en 16 octets), deux mesures de température (codées en 4 octets), et un mot (codé en 2 octets) indiquant le résultat du diagnostic de son électronique.

La puce de communication de la première unité secondaire N1 sélectionne alors le premier canal C1, puis elle émet la donnée d'entrée sur ce canal.

Si la communication est bonne, cette donnée d'entrée est reçue par l'unité principale M1 qui envoie en retour, sur le même canal C1, un message d'accusé de réception.

Cet intervalle de temps t1 présente une durée supérieure au temps nécessaire pour l'envoi de la donnée d'entrée et de l'accusé de réception. Cette marge de temps permet de s'affranchir des éventuels défauts de synchronisation entre les horloges des unités principale et secondaires.

Les onze intervalles de temps t2-t12 suivants se passent exactement de la même façon. Ils sont ainsi successivement utilisés par les onze autres unités secondaires N2-N12 pour communiquer leurs données d'entrée à l'unité principale M1 en utilisant respectivement onze autres canaux C2-C12.

Le quatorzième intervalle de temps t13 est utilisé par l'unité principale M1 pour communiquer des données de sortie aux douze unités secondaires N1-N12.

Le mode de transmission de données au cours de cet intervalle de temps t13 est donc un mode de diffusion (ou « broadcast » en anglais).

Les données de sortie forment des consignes que les modules 11 doivent appliquer.

Ces données de sortie comportent ainsi ici une information indiquant à chaque unité secondaire N1-N12 quelle cellule électrochimique 12 doit être équilibrée électriquement, et dans quelle mesure.

Le risque de cet échange de données sans fil est notamment que certaines données d'entrée n'aient pas été correctement reçues par l'unité principale M1.

L'idée consiste alors à demander à l'une des unités secondaires N1-N12 dont les données d'entrée n'ont pas été reçues de renvoyer ses données d'entrée au cours d'un dernier intervalle de temps t14.

Pour déterminer laquelle des unités secondaires N1-N12 doit réémettre des données, l'unité principale M1 procède de la façon suivante.

Au cours d'une première étape, elle détermine si elle a bien reçu les données d'entrée de toutes les unités secondaires N1-N12.

Pour cela, elle utilise ici un tableau tel que celui illustré sur la figure 3 qu'elle complète au fur et à mesure des intervalles de temps t1 à t12. Sur ce tableau, la seconde ligne représente les numéros de référence i des douze unités secondaires N1-N12, avec i compris entre 1 et 12.

La première ligne représente quant à elle un indicateur Ei relatif à la bonne réception des données d'entrée par l'unité principale M1.

Cet indicateur Ei est, en début de période de travail ΔT, fixé égal à zéro pour les douze unités secondaires N1-N12.

Puis, à chaque fois que l'unité principale M1 reçoit les données d'entrée de façon non corrompue de l'une de ces unités secondaires N1-N12, elle affecte la valeur 1 à l'indicateur Ei correspondant.

Ainsi, à l'issue des treize premiers intervalles de temps t0-t12, l'unité principale M1 peut détecter un éventuel problème de transmission en lisant les valeurs des indicateurs Ei.

Si tous les indicateurs Ei, avec i compris entre 1 et 12, sont égaux à 1, cela signifie que toutes les données d'entrée ont bien été reçues. Dans cette éventualité, le processus s'achève et rien ne se passe au cours de l'intervalle de temps t14.

Au contraire, si l'un au moins des états Ei est nul, cela signifie que les données d'entrée émises par l'une au moins des unités secondaires n'ont pas été bien reçues.

Dans cette éventualité, et notamment si les données envoyées par un ensemble de plusieurs unités secondaires N1-N12 n'ont pas bien été reçues, le calculateur va devoir opérer un choix afin de déterminer laquelle de ces unités secondaires pourra renvoyer ses données d'entrée au cours du dernier intervalle de temps t14.

L'idée consiste en effet à renvoyer les données d'entrée émises par une seule de ces unités secondaires, et de faire tourner à tour de rôle les unités secondaires qui peuvent réémettre leurs données d'entrée, à chaque période de travail ΔT successive.

Dans notre exemple illustré sur la figure 3, un ensemble de deux unités secondaires N6 et N10 n'est pas parvenu à transmettre ses données d'entrée à l'unité principale M1.

Pour définir laquelle de ces deux unités secondaires pourra renvoyer ses données d'entrée, il est défini un ordre de priorité.

Ici, cet ordre de priorité suit un sens prédéterminé. Dans notre exemple, ce sens est défini par une boucle dans laquelle l'unité secondaire N1 précède l'unité secondaire N2 qui précède l'unité secondaire N3, etc... Dans cette boucle, l'unité secondaire N12 précède l'unité secondaire N1.

Reste à définir le point de départ, c'est-à-dire l'unité secondaire qui a la priorité sur toutes les autres lors de la période de travail ΔT considérée.

Lors de la première période de travail ΔT (qui suit la mise sous contact du véhicule automobile), il s'agit par exemple de l'unité secondaire N1.

Par conséquent, la priorité est donnée à cette unité secondaire N1, puis successivement aux onze autres jusqu'à l'unité secondaire N12.

Dans l'exemple de la figure 3, l'unité principale M1 lit donc le tableau en suivant cet ordre de priorité et il en déduit que l'unité secondaire N6 est la première, dans l'ordre de priorité, qui n'a pas été en mesure de correctement transmettre ses données d'entrée à l'unité principale M1.

Dès lors, l'unité principale M1 peut, lors de l'intervalle de temps t13, informer cette unité secondaire N6 qu'elle va devoir retransmettre ses données d'entrée au cours du dernier intervalle de temps t14.

Elle pourrait également indiquer quel canal devra être utilisé. Toutefois, ici, le choix du canal pour la retransmission des données d'entrée suit une loi pseudo-aléatoire, qui est connue de toutes les unités principale et secondaire. Ainsi l'unité principale M1 et l'unité secondaire N6 savent quel canal choisir pour la retransmission des données d'entrée lors de l'intervalle de temps t14.

Ensuite, l'unité principale M1 va affecter comme nouveau point de départ à l'ordre de priorité l'unité secondaire N7 qui suit cette unité secondaire N6.

Ainsi, lors de la période de travail ΔT suivante où des données d'entrée n'ont pas été correctement reçues par l'unité principale M1, la priorité pour retransmettre les données d'entrée sera données à cette unité secondaire N7.

Pour illustrer cette éventualité, on peut considérer qu'au cours de la seconde période de travail ΔT, un problème affecte à nouveau les transmissions des données d'entrée entre les deux unités secondaire N6 et N10 et l'unité principale M1.

Alors, lorsque l'unité principale M1 lit donc le tableau en suivant le nouvel ordre de priorité, il constate que les unités secondaires N7, N8 et N9 sont bien parvenues à transmettre leurs données d'entrée, et il en déduit que l'unité secondaire N10 est la première, selon ce nouvel ordre de priorité, qui n'a pas été en mesure de correctement transmettre ses données d'entrée à l'unité principale M1.

Alors, ce sera cette fois cette unité secondaire N10 qui pourra retransmettre ses données d'entrée au cours de l'intervalle de temps t14.

Ce procédé permet donc d'assurer l'envoi à tour de rôle de toutes les données d'entrée qui n'auraient pas été reçues par l'unité principale.

On notera ici que lors de la seconde période de travail ΔT, on pourra utiliser des canaux différents de ceux utilisés pendant la première période de travail ΔT. Ainsi, la première unité secondaire pourra par exemple émettre ses données d'entrée sur le second canal C2.

La présente invention n'est nullement limitée au mode de réalisation décrit et représenté, mais l'homme du métier saura y apporter toute variante conforme à l'invention.

Ainsi, le point de départ dans la boucle définissant l'ordre de priorité pourrait être choisi différemment. On pourrait par exemple prévoir, lorsque plusieurs unités secondaires ne sont pas parvenues à transmettre leurs données d'entrée à l'unité principale, qu'une première de ces unités secondaires (suivant l'ordre de priorité) retransmette ses données d'entrée et qu'une seconde de ces unités secondaires soit choisie comme point de départ pour l'ordre de priorité lors de la période de travail suivante.

Encore en variante, on pourrait prévoir non pas un seul intervalle de temps t14 pour la retransmission de données à la fin de chaque période de travail ΔT, mais plusieurs de façon que plusieurs unités secondaires puissent retransmettre leurs données d'entrée. Dans cette variante, les deux premières unités secondaires selon l'ordre de priorité seraient alors choisies pour retransmettre leurs données d'entrée.

Dans le mode de réalisation décrit, l'architecture du réseau sans fil utilisé est dite « en étoile ». Ainsi, l'unité principale M1 est au centre de cette étoile puisque toutes les unités secondaires y sont directement connectées. En variante, tout autre type d'architecture réseau pourrait être utilisé. Une architecture dite « en arbre » pourrait ainsi être employée. Selon cette architecture, il serait prévu des unités secondaires, par exemple au nombre de deux ou trois, qui pourraient communiquer directement avec l'unité principale, les autres unités secondaires devant alors communiquer avec l'unité principale indirectement, via les premières unités secondaires.

## Revendications

1. Procédé de gestion d'une batterie d'accumulateurs (10) par un calculateur comprenant une unité principale (M1) et des unités secondaires (N1-N12) connectées ensemble par des moyens de communication sans fil, le procédé comprenant une opération récurrente d'échange de données entre l'unité principale (M1) et chaque unité secondaire (N1-N12) selon un ordre d'échange prédéterminé, à des intervalles de temps (t1-t13) successifs compris dans une période de travail (ΔT) déterminée, en utilisant au moins deux canaux distincts (C1-C12),
**caractérisé en ce qu'**il comprend, au cours de chaque opération récurrente d'échange de données, des étapes de :
- détection d'éventuel problème de transmission de données entre l'unité principale (M1) et un ensemble d'au moins une unité secondaire (N1-N12), puis, si ledit ensemble n'est pas vide,
- sélection d'une unique unité secondaire (N6) dans ledit ensemble, compte tenu d'un ordre de priorité prédéterminé, et
- retransmission de données entre ladite unique unité secondaire (N6) et l'unité principale (M1) pendant un intervalle de temps (t14) compris dans ladite période de travail (ΔT).

2. Procédé de gestion selon la revendication précédente, dans lequel, si ledit ensemble n'est pas vide, il est prévu une étape de modification de l'ordre de priorité à utiliser pour la période de travail (ΔT) suivante.

3. Procédé de gestion selon la revendication précédente, dans lequel, lors de l'étape de modification, l'ordre de priorité est modifié compte tenu de ladite unique unité secondaire (N6) sélectionnée.

4. Procédé de gestion selon la revendication précédente, dans lequel, les unités secondaires (N1-N12) étant ordonnées selon une boucle présentant un sens prédéterminé, lors de l'étape de modification, l'ordre de priorité est défini comme suivant le sens prédéterminé et comme partant de l'unité secondaire (N7) qui suit ladite unique unité secondaire (N6).

5. Procédé de gestion selon l'une des revendications précédentes, dans lequel ladite étape de sélection est mise en oeuvre par l'unité principale (M1) et dans lequel, avant l'étape de retransmission, il est prévu une étape d'émission par l'unité principale (M1) vers au moins ladite unique unité secondaire (N6) d'une information indiquant qu'elle a été sélectionnée.

6. Procédé de gestion selon l'une des revendications précédentes, dans lequel, durant l'opération récurrente d'échange de données, les données sont transmises depuis chaque unité secondaire (N1-N12) vers l'unité principale (M1) en utilisant un canal (C1-C12) à chaque fois différent.

7. Procédé de gestion selon l'une des revendications précédentes, dans lequel, durant l'opération récurrente d'échange de données, chaque unité secondaire (N1-N12) transmet à l'unité principale (M1) des données d'entrée caractérisant l'état de fonctionnement de cellules électrochimiques (12) de ladite batterie d'accumulateurs (10).

8. Procédé de gestion selon l'une des revendications précédentes, dans lequel, durant l'opération récurrente d'échange de données, l'unité principale (M1) transmet à chaque unité secondaire (N1-N12) des consignes d'équilibrage de cellules électrochimiques (12) de ladite batterie d'accumulateurs (10).

9. Batterie d'accumulateurs (10) comprenant :
- plusieurs ensembles de cellules électrochimiques (12), et
- un calculateur comportant une unité principale (M1) et des unités secondaires (N1-N12) qui sont chacune associées à un ensemble respectif de cellules électrochimiques (12) et qui sont connectées à l'unité principale (M1) par des moyens de communication sans fil,
**caractérisée en ce que** le calculateur est programmé pour mettre en oeuvre un procédé de gestion conforme à l'une quelconque des revendications précédentes.

10. Véhicule automobile comportant un moteur électrique, **caractérisé en ce qu'**il comporte en outre une batterie d'accumulateurs conforme à la revendication précédente.

## Patentansprüche

1. Verfahren zur Steuerung eines Akkupacks (10) durch einen Rechner, der eine Haupteinheit (M1) und Sekundäreinheiten (N1-N12) beinhaltet, die durch drahtlose Kommunikationsmittel untereinander verbunden sind, wobei das Verfahren einen sich wiederholenden Vorgang zum Austausch von Daten zwischen der Haupteinheit (M1) und jeder Sekundäreinheit (N1-N12) gemäß einer vorgegebenen Austauschreihenfolge in aufeinanderfolgenden Zeitintervallen (t1-t13), die in einem bestimmten Arbeitszeitraum (ΔT) enthalten sind, beinhaltet, unter Verwendung von mindestens zwei unterschiedlichen Kanälen (C1-C12),
**dadurch gekennzeichnet, dass** es während jedes sich wiederholenden Vorgangs zum Austausch von Daten die folgenden Schritte beinhaltet:
- Detektieren eines möglichen Problems bei der Übertragung von Daten zwischen der Haupteinheit (M1) und einem Satz aus mindestens einer Sekundäreinheit (N1-N12), und dann, wenn der Satz nicht leer ist,
- Auswählen einer einzelnen Sekundäreinheit (N6) aus dem Satz unter Berücksichtigung einer vorgegebenen Prioritätsreihenfolge und
- erneutes Übertragen von Daten zwischen der einzelnen Sekundäreinheit (N6) und der Haupteinheit (M1) während eines Zeitintervalls (t14), der in dem Arbeitszeitraum (ΔT) enthalten ist.

2. Steuerungsverfahren nach dem vorhergehenden Anspruch, wobei, wenn der Satz nicht leer ist, ein Schritt des Änderns der für den nachfolgenden Arbeitszeitraum (ΔT) zu verwendenden Prioritätsreihenfolge vorgesehen ist.

3. Steuerungsverfahren nach dem vorhergehenden Anspruch, wobei während des Schritts des Änderns die Prioritätsreihenfolge unter Berücksichtigung der ausgewählten einzelnen Sekundäreinheit (N6) geändert wird.

4. Steuerungsverfahren nach dem vorhergehenden Anspruch, wobei, wenn die Sekundäreinheiten (N1-N12) gemäß einer Schleife mit einer vorgegebenen Richtung geordnet sind, während des Schritts des Änderns die Prioritätsreihenfolge so definiert wird, dass sie der vorgegebenen Richtung folgt und bei derjenigen Sekundäreinheit (N7) ihren Anfang nimmt, die auf die einzelne Sekundäreinheit (N6) folgt.

5. Steuerungsverfahren nach einem der vorhergehenden Ansprüche, wobei der Schritt des Auswählens durch die Haupteinheit (M1) umgesetzt wird und wobei vor dem Schritt des erneuten Übertragens ein Schritt des Sendens, durch die Haupteinheit (M1) an mindestens die eine einzelne Sekundäreinheit (N6), einer Information vorgesehen ist, die ihre Auswahl anzeigt.

6. Steuerungsverfahren nach einem der vorhergehenden Ansprüche, wobei während des sich wiederholenden Vorgangs zum Austausch von Daten die Daten unter Verwendung eines Kanals (C1-C12), der jedes Mal ein anderer ist, von jeder Sekundäreinheit (N1-N12) an die Haupteinheit (M1) übertragen werden.

7. Steuerungsverfahren nach einem der vorhergehenden Ansprüche, wobei während des sich wiederholenden Vorgangs zum Austausch von Daten jede Sekundäreinheit (N1-N12) Eingangsdaten an die Haupteinheit (M1) überträgt, die den Betriebszustand elektrochemischer Zellen (12) des Akkupacks (10) definieren.

8. Steuerungsverfahren nach einem der vorhergehenden Ansprüche, wobei während des sich wiederholenden Vorgangs zum Austausch von Daten die Haupteinheit (M1) Vorgaben für einen Abgleich elektrochemischer Zellen (12) des Akkupacks (10) an jede Sekundäreinheit (N1-N12) überträgt.

9. Akkupack (10), das Folgendes beinhaltet:
- mehrere Sätze elektrochemischer Zellen (12) und
- einen Rechner, der eine Haupteinheit (M1) und Sekundäreinheiten (N1-N12), die jeweils mit einem jeweiligen Satz elektrochemischer Zellen (12) assoziiert sind und durch drahtlose Kommunikationsmittel mit der Haupteinheit (M1) verbunden sind, umfasst,
**dadurch gekennzeichnet, dass** der Rechner dazu programmiert ist, ein Steuerungsverfahren nach einem beliebigen der vorhergehenden Ansprüche umzusetzen.

10. Kraftfahrzeug, das einen Elektromotor umfasst, **dadurch gekennzeichnet, dass** es ferner ein Akkupack nach dem vorhergehenden Anspruch umfasst.

## Claims

1. Method for managing a battery pack (10) by means of a computer comprising a main unit (M1) and secondary units (N1-N12) connected to one another by wireless communication means, the method comprising a recurrent operation of exchanging data between the main unit (M1) and each secondary unit (N1-N12) in a predetermined order of exchange, at successive time intervals (t1-t13) contained in a determined work period (ΔT), using at least two distinct channels (C1-C12),
**characterized in that** it comprises, over the course of each recurrent data exchange operation, steps of:
- detecting a possible problem with transmitting data between the main unit (M1) and a set of at least one secondary unit (N1-N12), then, if said set is not empty,
- selecting a single secondary unit (N6) from said set, taking a predetermined order of priority into account, and
- retransmitting data between said single secondary unit (N6) and the main unit (M1) during a time interval (t14) contained in said work period (ΔT).

2. Management method according to the preceding claim, wherein, if said set is not empty, provision is made for a step of modifying the order of priority to be used for the following work period (ΔT).

3. Management method according to the preceding claim, wherein, during the modification step, the order of priority is modified taking said single selected secondary unit (N6) into account.

4. Management method according to the preceding claim, wherein, with the secondary units (N1-N12) being ordered in a loop having a predetermined direction, during the modification step, the order of priority is defined as following the predetermined direction and as starting from the secondary unit (N7) which follows said single secondary unit (N6).

5. Management method according to one of the preceding claims, wherein said selection step is implemented by the main unit (M1) and wherein, before the retransmission step, provision is made for a step of the main unit (M1) transmitting, to at least said single secondary unit (N6), information indicating that it has been selected.

6. Management method according to one of the preceding claims, wherein, during the recurrent data exchange operation, the data are transmitted from each secondary unit (N1-N12) to the main unit (M1) using a different channel (C1-C12) each time.

7. Management method according to one of the preceding claims, wherein, during the recurrent data exchange operation, each secondary unit (N1-N12) transmits, to the main unit (M1), input data characterizing the operating state of electrochemical cells (12) of said battery pack (10) .

8. Management method according to one of the preceding claims, wherein, during the recurrent data exchange operation, the main unit (M1) transmits, to each secondary unit (N1-N12), setpoints for balancing electrochemical cells (12) of said battery pack (10).

9. Battery pack (10) comprising:
- several sets of electrochemical cells (12), and
- a computer comprising a main unit (M1) and secondary units (N1-N12) which are each associated with a respective set of electrochemical cells (12) and which are connected to the main unit (M1) by wireless communication means,
**characterized in that** the computer is programmed to implement a management method in accordance with any one of the preceding claims.

10. Motor vehicle comprising an electric motor, **characterized in that** it further comprises a battery pack in accordance with the preceding claim.
